# EUROPÄISCHE PATENTSCHRIFT

(11) **EP 0 838 134 B1**
(45) Veröffentlichungstag und Bekanntmachung des Hinweises auf die Patenterteilung: **26.05.1999**
(21) Anmeldenummer: 96925716.1
(22) Anmeldetag: 05.07.1996
(51) Int. Cl.: H05K 3/00, B05B 1/34

(54) **VERFAHREN UND VORRICHTUNG ZUM CHEMISCHEN UND ELEKTROLYTISCHEN BEHANDELN VON LEITERPLATTEN UND LEITERFOLIEN**
PROCEDURE AND DEVICE FOR THE CHEMICAL AND ELECTROLYTIC TREATMENT OF PRINTED CIRCUIT BOARDS AND FILMS
PROCEDE ET DISPOSITIF POUR LE TRAITEMENT CHIMIQUE ET ELECTROLYTIQUE DE PLAQUETTES ET DE FEUILLES A CIRCUITS IMPRIMES

(30) Priorität: 05.07.1995 DE 19524523
(43) Veröffentlichungstag der Anmeldung: 29.04.1998
(73) Patentinhaber: ATOTECH Deutschland GmbH, 10553 Berlin (DE)
(72) Erfinder: BARON, David T., 9 Gloucester Way, Worcestershire DY12 1QF (GB); SCHNEIDER, Reinhard, D-90556 Cadolzburg (DE)
(74) Vertreter: Effert, Bressel und Kollegen
(86) Internationale Anmeldenummer: EP9603032
(87) Internationale Veröffentlichungsnummer: WO9702724

(56) Entgegenhaltungen:
- EP-A- 0 212 253
- EP-A- 0 443 380
- DE-A- 2 433 653
- DE-A- 3 813 518
- PATENT ABSTRACTS OF JAPAN vol. 18, no. 66 (E-1501), 3.Februar 1994 & JP,A,05 283852 (NEC CORP), 29.Oktober 1993,
- PATENT ABSTRACTS OF JAPAN vol. 17, no. 190 (C-1048), 14.April 1993 & JP,A,04 341590 (NKK CORP), 27.November 1992, in der Anmeldung erwähnt
- PATENT ABSTRACTS OF JAPAN vol. 17, no. 190 (C-1048), 14.April 1993 & JP,A,04 341589 (NKK CORP), 27.November 1992, in der Anmeldung erwähnt
- PATENT ABSTRACTS OF JAPAN vol. 17, no. 190 (C-1048), 14.April 1993 & JP,A,04 341588 (NKK CORP), 27.November 1992, in der Anmeldung erwähnt

## Beschreibung

Die Erfindung betrifft ein Verfahren zum chemischen und elektrolytischen Behandeln sowie Spülen von Leiterplatten und Leiterfolien mit hoher Präzision und Geschwindigkeit mit einer Behandlungsflüssigkeit sowie eine Vorrichtung zur Durchführung des Verfahrens und deren Verwendung.

Zu diesen Behandlungsverfahren gehören insbesondere das Galvanisieren, Filmentwickeln, Filmstrippen, Ätzen und Metallresiststrippen sowie die Spülschritte vor und nach diesen Prozessen. Allen Prozessen gemeinsam ist, daß ein Stoffaustausch an den Oberflächen notwendig ist. Die Intensität des Stoffaustausches beeinflußt entscheidend die Behandlungszeit. Deshalb wird angestrebt, unter Einbeziehung der prozeßspezifischen Anforderungen den Stoffaustausch an den Oberflächen der Leiterplatten zu steigern. Die genannten Anforderungen werden insbesondere durch die technische Entwicklung in Richtung der Feinleitertechnik mit Feinbohrungen gesteigert. Bei der Behandlung von Leiterplatten mit Leiterbahnbreiten und -abständen in der Größenordnung bis herab zu 0.05 mm und Bohrungen mit Durchmessern bis hinunter zu 0,15 mm wird der Stoffaustausch zusätzlich behindert. Die in dieser Technik geforderte Präzision (Genauigkeit der einzuhaltenden Toleranzen der Metallschichtdicken, Leiterbahnbreiten und -abstände, Reinheit der behandelten Oberflächen) stößt jedoch bei Verlängerung der Behandlungszeiten an die Grenze des technisch Machbaren.

Folgende prozeßspezifische Anforderungen bestehen daher:
- Galvanisieren:
   Gebohrte, durchkontaktierte Leiterplatten sind elektrolytisch zu verstärken. Ferner sind Leiterbahnen, die von Resist begrenzt sind, zu verstärken. In beiden Fällen ist eine gleichmäßige Schichtdickenverteilung über der gesamten Oberfläche der Leiterplatte einschließlich in den Löchern notwendig. Ferner wird eine kurze Behandlungszeit, das heißt eine hohe Stromdichte, angestrebt. Die Strukturen der Feinleitertechnik sowie die vorkommenden feinen Löcher und insbesondere die Sacklöcher setzen hier enge Grenzen. Die Präzision der elektrolytischen Behandlung muß mit löslichen und unlöslichen Anoden erzielbar sein.
- Filmentwickeln:
   Die kupferkaschierte, gebohrte und durchkontaktierte Leiterplatte wird vollflächig mit Photoresist, auch Film genannt, beschichtet. Die Schichtdicke beträgt 60 bis 80 µm. Die nicht belichteten Stellen müssen entwickelt, das heißt vom Film befreit werden. Bei 50 µm breiten Strukturen ist der herauszuentwickelnde Kanal schmaler als seine Höhe. Durch diffuses Streulicht bei der Belichtung härten, insbesondere am Boden, auch Flanken der zu entwickelnden Kanäle mehr oder weniger trapezförmig aus. Die vollständige Entfernung des nicht entwickelten Resistes und des teilweise entwickelten Resistes aus den schmalen Kanälen ist notwendig. Zugleich dürfen die belichteten und damit ausgehärteten Stellen nicht beschädigt oder am Grund von der Kupferschicht abgelöst werden.
- Filmstrippen:
   Nach der elektrolytischen Kupferverstärkung muß der harte und haftfeste Film wieder entfernt werden. Gefordert wird ein großflächiges Ablösen des Filmes, damit seine Filtration aus der Badlösung technisch einfach bleibt. Die oben beschriebenen trapezförmigen Querschnitte führen zu einem Einschluß des Filmes durch das abgeschiedene Kupfer. Gleiches bewirkt eine Kupferschicht, die über den oberen Rand des Resistes pilzförmig hinauswächst. Die so eingeschlossenen Resistbereiche müssen ebenfalls vollständig entfernt werden. Auch hierbei soll ein Ablösen und weniger ein Auflösen erfolgen, so daß das Herausfiltern des Filmes aus der Behandlungsflüssigkeit möglich bleibt.
- Ätzen:
   Die vom Photoresist befreiten Kupferflächen werden bis zum Basismaterial der Leiterplatten chemisch abgeätzt. Die übrigen Leiterbahnen und Löcher sind mit einem Ätzresist geschützt. Nicht geschützt sind die seitlichen Flanken der Leiterbahnen, die vom Photoresist befreit wurden, sowie die erst beim Ätzen entstehenden Flanken. Das vollständige Herausätzen der Kupferschicht muß bei minimalem Flankenangriff erfolgen. Deshalb besteht die Forderung nach einer schnellen und sehr gleichförmigen Bearbeitung der Leiterplatten an ihren Ober- und Unterseiten über die gesamten Flächen. Besonders kritisch beim Ätzen sind Leiterplatten mit Dickenunterschieden der Kupferschicht. Die notwendigerweise längeren Ätzzeiten dürfen nicht zur Unterätzung führen.
- Metallresiststrippen:
   Die Entfernung des Metallresistes wie zum Beispiel einer Zinn/BleiSchicht erfolgt ebenfalls chemisch. Die Ätzlösung erreicht auch die ungeschützten Kupferflanken der Leiterzüge. An diesen Stellen besteht die Gefahr der Kupferablösung. Deshalb ist auch für das Metallresiststrippen eine sehr gleichmäßige Bearbeitung über die gesamte Oberfläche der Leiterplatte notwendig. Nur dies erlaubt die kürzestmögliche Behandlungszeit und damit den geringsten Kupferangriff.
- Spülen:
   Das Spülen vor und nach den einzelnen Prozeßschritten der Leiterplattentechnik soll aus Kostengründen und aus Gründen der Umweltbelastung unter minimalem Einsatz von Spülmitteln erfolgen. Zugleich soll die Spülzeit kurz gehalten werden. Dem Spülen sind Prozeßschritte wie Dekapieren (Behandeln mit verdünnter Schwefelsäure), Konditionieren und Aktivieren beim Durchkontaktieren mit dem stromlosen Metallisierungsverfahren gleichzusetzen.

Die beschriebenen Prozesse benötigen zur Beschleunigung einen intensiven Stoffaustausch in der Diffusionsschicht der zu behandelnden Oberflächen. Bei diesen Oberflächen handelt es sich immer um Grenzflächen, die relativ zum flüssigen Behandlungsmedium bewegt werden. Im Nahbereich, in dem der chemische und elektrolytische Prozeß auf der Oberfläche stattfindet, geht die relative Flüssigkeitsbewegung gegen Null (Diffusionsgrenzschicht). In der Diffusionsgrenzschicht haftet Flüssigkeit an der Oberfläche des Behandlungsgutes. Der Nahbereich in der Diffusionschicht wird als viskose Unterschicht bezeichnet. Ein Flüssigkeitsaustausch findet hier auch dann nicht statt, wenn starke Makrobewegungen der Flüssigkeit relativ zur Oberfläche stattfinden (Konvektion). Bestenfalls wird die Diffusionsgrenzschicht an der zu behandelnden Oberfläche dünner. Der Prozeß selbst bleibt diffusionskontrolliert.

Bekannte Makrobewegungen sind zum Beispiel das Bewegen der Leiterplatten, Anströmen, Anspritzen und Schwallen. Damit wird frische Behandlungsflüssigkeit, das heißt chemisch aktives Medium. an die Diffusionsschicht herangefördert und gegen verbrauchtes ausgetauscht. Dieser Vorgang wird als Makrostoffaustausch bezeichnet. Der Stoffaustausch in der Diffusionsschicht wird als Mikrostoffaustausch bezeichnet. Hierunter soll in dieser Beschreibung nicht der Stoffaustausch durch Diffusion verstanden werden. Bekannte Maßnahmen zur Einleitung eines Mikrostoffaustausches sind zum Beispiel das Wischen der Oberflächen oder die Anwendung von Ultraschall.

Technische und physikalische Probleme sind Gründe dafür, daß die großtechnische Anwendung dieser Maßnahmen bei den chemischen Leiterplattenprozessen nicht erfolgt. Geeignete verschleißfeste Wischwerkstoffe konnten bisher nicht gefunden werden.

Die Wirkung von Ultraschall geht durch die Makroströmung verloren. Die Ultraschallwirkung beruht auf der Erzeugung von Kavitationsblasen, die an der Diffusionsschicht implodieren sollen. Beim Implodieren setzen sie im Mikrobereich große Kräfte frei, die den Mikrostoffaustausch bewirken können. Bekannt ist bei schwingenden Ultraschallgeneratoren, daß die Entstehung der Kavitationsblasen quasi statisch und schichtweise im Abstand λ/2 vom Ultraschallgenerator im Bad erfolgt (λ = Wellenlänge der Ultraschallschwingungen). Dies bedeutet, daß nur ein Teil der Blasen in der Nähe des Behandlungsgutes entsteht, wo sie wirken sollen. Zur Entstehung der Blasen wird Zeit benötigt. Ferner wird beobachtet, daß sich in dieser Zeit die umgebende Flüssigkeit nicht wesentlich bewegen darf. Die entstehende Kavitationsblase muß an ihrem Entstehungsort bleiben, sonst bildet sie sich nicht aus.

Die Praxis zeigt, daß die Geschwindigkeit einer Flüssigkeit, in der Kavitationsblasen erzeugt werden sollen, nicht größer sein darf als 0,06 Meter pro Sekunde. Deshalb kann Ultraschall nur in ruhenden Bädern wirksam angewendet werden. Dies schließt aber den beschriebenen Makrostoffaustausch durch Strömung aus. Daher steht für den Mikrostoffaustausch mittels implodierender Kavitationsblasen, die von Ultraschall erzeugt werden, kein Nachschub frischer Behandlungsflüssigkeit zur Verfügung. Dies ist der Grund dafür, daß Ultraschall nur bei Reinigungsprozessen breite Anwendung findet. Hier werden Verunreinigungen wie Bohr-, Schleif- oder Polierreste durch die Ultraschallwirkung abgesprengt. Ein chemischer oder elektrolytischer Prozeß findet nicht statt. Deshalb ist auch ein Heranführen von aktiver Behandlungsflüssigkeit von untergeordneter Bedeutung, so daß eine starke Makroströmung in der Nähe des Behandlungsgutes nicht erforderlich ist. Beim Reinigen sorgt das Implodieren der Kavitationsblasen hauptsächlich für die notwendige mechanische Unterstützung. Die eingangs beschriebenen Prozesse der Leiterplattentechnik sind dagegen chemische oder elektrolytische Prozesse an bereits gereinigten Oberflächen. Diese Prozesse haben einen sehr großen Bedarf an Metallionen beziehungsweise Chemikalien, die an der Leiterplattenoberfläche reagieren müssen. Dieser Bedarf kann nur durch den Makrostoffaustausch gedeckt werden. Er muß sehr gleichmäßig über die gesamte Oberfläche jeder Leiterplatte stattfinden. Insbesondere bei Feinleiterplatten bereiten dabei die Leiterbahnbreiten und die Dicke des Resistes ähnliche Probleme wie sie von der Lochbearbeitung bekannt sind. Die Feinleiter entsprechen Feinlöchern mit einem Aspektenverhältnis (Breite des Resistkanals bzw. -steges zur Tiefe des Kanals bzw. Höhe des Steges; aspect ratio) von etwa 1: 2. Zur gleichmäßigen, qualitativ hochwertigen Behandlung solcher Strukturen wird nach dem Stand der Technik unwirtschaftlich in die ebenfalls problematische Verlängerung der Behandlungszeit ausgewichen.

Das horizontale chemische Bearbeiten der Leiterplatten erfolgt vorzugsweise in Spritztechnik. Hierzu gibt es in der Literatur Beispiele und Vorschläge zu technischen Ausführungen. Die Ätztechnik wird nachfolgend als typischer Anwendungsfall beschrieben:

Düsenstöcke bewegen sich relativ zum Behandlungsgut. Oszillierende und/oder schwenkende Bewegungen können überlagert sein. In den Düsenstöcken kommen zum Beispiel Vollkegeldüsen. Flachstrahldüsen und Bündeldüsen zum Einsatz. Die Behandlungsflüssigkeit wird unter hohem oder mittlerem Druck durch die Düsen an die Oberflächen gespritzt. Das scharf abgegrenzte Spritzbild hat in der Regel immer Überlappungen. In diesen Bereichen wird die Oberfläche intensiver behandelt. Die von der oberen Oberfläche abfließende Behandlungsflüssigkeit erreicht zusätzlich auch die Randbereiche der Leiterplatte. In diesen Bereichen wird daher die Oberfläche ebenfalls intensiver bearbeitet. Das Abfließen wird ferner von der Richtung der Leiterzüge auf den Leiterplatten beeinflußt. Quer zur Abflußrichtung liegende Leiterzüge verringern die Abflußgeschwindigkeit bis hin zur Pfützenbildung, die als "puddle effect" bekannt ist. Trotz unterschiedlichster Steuerungen des Spritzmediums auf den Oberflächen der Leiterplatten bleibt die erzielbare Gleichmäßigkeit bei der Spritzbehandlung ein Problem, insbesondere bei Feinleiterplatten. Vorteilhaft, aber auch notwendig, ist die erzielbare kurze Spritzbehandlungszeit. Das Spritzen hat einen weiteren grundsätzlichen Nachteil, nämlich den Eintrag von Luft in die Behandlungsflüssigkeit. Dies führt zur starken Schaumbildung. Deshalb müssen den Behandlungsflüssigkeiten Mittel zugegeben werden, die das Schäumen unterbinden. Diese Mittel sind als Antifoam (Antischaummitel) bekannt. Sie sind unverträglich mit vielen Chemikalien, die an sich zur Behandlung der Leiterplatten sehr gut geeignet wären. Die Chemikalienauswahl ist daher eingeschränkt. Antifoam stellt auch ein Problem bei der Abwasserbehandlung und den dafür erforderlichen Kosten dar. Die Leiterplatte hat bei der Spritzbehandlung Luftkontakt. Zusätzlich wird permanent Luftsauerstoff eingetragen. Oxidative Reaktionen an den Leiterplatten sowie mit Stoffen in der Behandlungsflüssigkeit sind die Folge. Auch aus diesem Grunde scheiden ansonsten geeignete Stoffe für diese Flüssigkeiten aus. Des weiteren wirken sich Oxide am Kupfer negativ aus.

Durch die Spritzbehandlung wird, wenn auch ungleichmäßig, unverbrauchte Behandlungsflüssigkeit in ausreichender Menge an die Oberflächen der Leiterplatten herantransportiert. Dies bewirkt die akzeptabel kurze Behandlungszeit. Die Behandlungsflüssigkeit gelangt jedoch nicht zur viskosen Unterschicht der Diffusionsschicht. Beim Spritzen findet nur ein Stoffaustausch durch Diffusion statt. Eine Beschleunigung der Spritzbehandlung läßt sich durch Ultraschall nicht erreichen. Bei Anwenaung von Ultraschall ist es notwendig, die üblicherweise als Resonanzschwinger betriebenen Ultraschallgeneratoren einer konstanten Dämpfung auszusetzen. Andernfalls zerstören zu große Amplituden den Generator. Zur Dämpfung dient eine den Generator permanent umgebende Flüssigkeit. Diese führt zugleich entstehende Verlustwärme ab. Außerdem kann die Ultraschallenergie auch nur mittels intensiven Kontakts über die Behandlungsflüssigkeit wirkungsvoll an die Leiterplattenoberfläche herangeführt werden (Einkopplung). Praktisch muß sich der Ultraschallgenerator in ruhender Flüssigkeit unter Badspiegel befinden, was beim Spritzen nicht möglich ist. Der Mikrostoffaustausch durch Ultraschalleinsatz und der Makrostoffaustausch durch die Spritztechnik schließen sich somit gegenseitig aus.

Auch die elektrolytische Behandlung im getauchten Zustand erfordert einen intensiven Makrostoffaustausch, der durch Elektrolytanströmung erzielt wird. Dies schließt wiederum die gleichzeitige Anwendung von schwingenden Ultraschallgeneratoren zur Erzeugung von Kavitationsblasen an den Leiterplattenoberflächen aus. Bei der elektrolytischen Metallisierung ist die Elektrolytströmung wesentlich größer als sie zur Entstehung der Kavitationsblasen sein darf.

Nach dem Stand der Technik sind eine Vielzahl von Vorrichtungen zur galvanotechnischen Behandlung von Metallteilen bekannt, bei denen zur Verbesserung des Stoffaustausches Ultraschallschwinger eingesetzt werden. Beispielsweise wird in den japanischen Offenlegungsschriften 4-34 15 88, 4-34 15 89 und 4-34 15 90 eine Anordnung für die Behandlung von Stahlband vorgeschlagen, das in einer Beizlösung an Ultraschallschwingern vorbeibewegt wird, die ebenfalls in die Beizlösung eingetaucht sind und deren Ultraschallwellen auf die Stahlbandoberflächen fokussiert werden.

In der Druckschrift EP 0 212 253 A2 wird ein Verfahren zur Reinigung und Aktivierung von Bohrlöchern in horizontal geführten Leiterplatten beschrieben, in der die Ultraschallanwendung vorgeschlagen wird. Eine längsgeschlitzte sogenannte Schwalldüse ist in etwa 1 mm Abstand von der Leiterplattenoberfläche angeordnet. Die Schwalldüse stellt eine besondere Ausführungsform der vorstehend beschriebenen Spritzregister dar. Mit ihrer Hilfe werden zugleich mit den Löchern auch die Oberflächen der Leiterplatten bearbeitet. Im Vergleich zu den Spritzdüsen ist der Stoffaustausch an den Leiterplattenoberflächen wegen der möglichen geringeren Fließgeschwindigkeit der Behandlungsflüssigkeit jedoch kleiner. Die Diffusionsschicht wird daher weniger gestört.

Deshalb wird in der Druckschrift auch eine Ultraschallunterstützung vorgeschlagen, wobei der Ultraschallschwinger in einer Ausführungsform auf der der Schwalldüse gegenüberliegenden Seite der Leiterplatte in deren nächster Nähe angeordnet ist. Da der Ultraschallschwinger jedoch oberhalb des Badspiegels angeordnet ist, kann das Ultraschallfeld nur ungenügend und nicht reproduzierbar in die an der Oberfläche des Behandlungsgutes anhaftende Behandlungsflüssigkeit angekoppelt werden. Technisch verfügbare Ultraschall-Piezoschwinger sind zur Realisierung dieses Vorschlages ungeeignet.

In einer anderen Ausführungsform befindet sich der Ultraschallschwinger innerhalb des Düsengehäuses. Da aber nach der Funktionsweise der Düse die Geschwindigkeit des Flüssigkeitsstromes durch die Düse mindestens 0,6 Meter pro Sekunde beträgt, wäre in diesem Fall mit folgendem zu rechnen: Die Kavitationsblasen entstehen im Abstand λ/2 vom Generator und verbleiben im wesentlichen dort. Bevorzugt jedoch entstehen sie auch an Unstetigkeitsfehlstellen der Flüssigkeit. Die Oberflächen des Behälters, beispielsweise des Düseninnenraumes, und die Wände der Düse sind solche Stellen. An den Wänden implodieren die Kavitationsblasen und greifen sie dabei massiv an. Die Folge ist, daß der überwiegende Teil der entstehenden Kavitationsblasen zerstörend auf die Schwalldüse selbst wirken würden, ohne aus der Düse austreten zu können. Daher bleibt als Wirkung dieser Ausführungsform praktisch nur der Schwall der Behandlungsflüssigkeit gegen die Leiterplattenoberfläche übrig.

Ein weiterer Nachteil der Schwalldüse besteht darin, daß nur die Spaltbreite der Düse für die Flüssigkeitsbehandlung wirksam ist. Eine Schwalldüse stellt somit nur eine kurze Behandlungsstrecke dar. Deshalb sind zur Leiterplattenbehandlung je Prozeß mehrere quer zur horizontalen Transportrichtung angeordnete Schwalldüsen erforderlich. Dazwischen müssen ausreichend viele Transportführungsrollen angeordnet sein, um den kleinen Abstand von 1 mm zwischen Leiterplatte und Schwalldüse sicher einhalten zu können. Bei Leiterfolien erweist sich dies als ein besonders großes Problem. Das empfindliche Behandlungsgut darf nicht an den Schwalldüsen entlangschleifen. Dies würde zur Beschädigung der Folienoberfläche und den Leiterbahnen führen. Die kurzen und deshalb in großer Anzahl benötigten Schwallbehandlungsstrecken sowie die nötigen dazwischenliegenden Transportrollen führen zu großen Anlagenlängen mit entsprechend hohen Kosten.

Eine weitere Anordnung zur Verbesserung des Stoffaustausches, inbesondere in feinen Löchern von Leiterplatten, ist in der Druckschrift DE 38 13 518 A1 beschrieben. Dort ist eine Maschine zum Reinigen und/oder Spülen von Bohrungen in Leiterplatten offenbart, bei der die Leiterplatten in horizontaler Lage und horizontaler Richtung durch an einer Druckdüse und einer dieser gegenüberliegenden Saugdüse auf der anderen Seite der Transportebene vorbeigeführt werden. Hiermit soll ebenfalls ein verbesserter Stoffaustausch erreicht werden. Allerdings werden keine Vorschläge gemacht, die Behandlungswirkung durch Ultraschalleinsatz zu verstärken, so daß für einen wirksamen Stoffaustausch an der Grenzfläche der Leiterplatten zur Behandlungsflüssigkeit nur die relativ schwache Makroströmung zur Verfügung steht.

In der deutschen Offenlegungsschft 24 33 653 werden ein Verfahren zum Behandeln eines Fluids und dessen Verwendung zum Behandeln eines Gegenstandes sowie eine Vorrichtung zur Durchführung des Verfahrens offenbart. In der beschriebenen Vorrichtung wird eine Wirbelströmung in der Flüssigkeit erzeugt, so daß die aus der Vorrichtung austretende Flüssigkeit einer Kavitationswirkung unterworfen wird. Mit dem vorgeschlagenen Verfahren und der Vorrichtung ist es möglich, Gegenstände, beispielsweise Formgußteile, wirksam zu säubern, zu entzundern und abzubeizen. Hierzu sollen die Teile in einen Tank, in dem sich die Behandlungsflüssigkeit befindet, eingetaucht werden und mittels seitlich angebrachter Düsen, aus denen die der Kavitation unterworfene Flüssigkeit unter starkem Druck austritt, mit dieser behandelt.

Ferner ist es auch bekannt, ein Verfahren zum hydrodynamischen Erzeugen von Kavaitation unterworfener Flüssigkeitsströmung in Entfettungs- und Spülbädern, zur Behandlung von Gut in Trommeln, Körben und an Gestellen einzusetzen. Eine derartige Anlage ist in dem vorveröffentlichten Prospekt "Reinigen mit Hydroson" der Firma Atotech Deutschland GmbH, Berlin, DE angegeben.

Obwohl das Verfahren zur hydrodynamischen Erzeugung von prozeßbeschleunigenden Kavitationsblasen bekannt ist, wurde in der Leiterplattentechnik bisher ein anderer Weg zur wirksamen Behandlung von Leiterplatten eingeschlagen. Seit vielen Jahren wird versucht, durch Ultraschallanwendung mittels schwingender Generatoren Verbesserungen und/oder Beschleunigungen der chemischen und elektrolytischen Prozesse zu erreichen. Die vielen technischen Vorschläge in der Literatur führten nicht zur großtechnischen Anwendung, weil eine wirksame Unterstützung dieser Leiterplattenprozesse damit bisher nicht gelungen ist.

Auch bei einer der hydrodynamischen Erzeugung von Kavitation unterworfenen Flüssigkeitsströmung ist der Abstand der Düsenöffnungen, aus denen die Strömung austritt, vom Behandlungsgut zu beachten. Zwar ist es nicht wie bei der Verwendung der Schwallwelle erforderlich, daß ein sehr geringer und konstanter Abstand von der Düsenöffnung eingehalten wird. Da die Nachteile der Spritzdüsen, die sich beispielsweise als starke Schaumentwicklung bemerkbar machen können, vermieden werden sollen, sollte der Flüssigkeitsstrahl möglichst innerhalb der Behandlungsflüssigkeit aus der Düsenöffnung austreten. Daher muß ein maximaler Abstand der Düsenöffnung von der Oberfläche des Behandlungsgutes eingehalten werden, da der Flüssigkeitsstrahl durch die Reibung in der im wesentlichen ruhenden Behandlungsflüssigkeit schnell an kinetischer Energie verliert, der Strahlkegel aufweitet und die Kavitationsblasen teilweise bereits in der Lösung zerfallen.

Der vorliegenden Erfindung liegt von daher das Problem zugrunde, ein Verfahren zu finden, mit dem die Nachteile des Standes der Technik vermieden werden können. Insbesondere soll ein Verfahren zur chemischen und elektrolytischen Behandlung sowie Spülung von Leiterplatten und Leiterfolien einschließlich der Löcher und Sacklöcher gefunden werden, das vorzugsweise für die beschriebenen Anforderungen in der Feinieitertechnik geeignet ist. Es sollen zugleich bei hoher Präzision der Flüssigkeitsbehandlung kurze Behandlungszeiten und damit kurze Anlagenlängen erzielt werden.

Zur Lösung des Problems wird ein Verfahren vorgeschlagen, das durch die Merkmale des Anspruchs 1 gekennzeichnet ist. Es ermöglicht im Einklang mit den beschriebenen prozeßspezifischen Anforderungen den gleichzeitigen Makro- und Mikrostoffaustausch an den zu behandelnden Oberflächen. Hierzu wird zweckmäßig ein Kavitationsgenerator entsprechend der deutschen Offenlegungsschrift 24 33 653 unter Baaspiegei in einem Versuchsbad mit horizontaler Anordnung und Transportrichtung der Leiterplatten angeordnet.

Die erfindungsgemäße Vorrichtung ist gekennzeichnet durch die Merkmale des Anspruchs 11. Sie umfaßt einen Behälter zur Aufnahme von Behandlungsflüssigkeit, Mittel zum Transport der oberhalb des Behälters geführten und in horizontaler Lage angeordneten Leiterplatten in horizontaler Richtung, Mittel zum Bilden eines Flüssigkeitsstauraumes an der Oberseite der Leiterplatten, Düsen (Kavitationsgeneratoren) zum Fördern der Behandlungsflüssigkeit an die Oberflächen der Leiterplatten und mindestens eine Pumpe zum Fördern der Behandlungsflüssigkeit in die Düsen mit einem Druck von mindestens 10 bar. In den Düsen ist zur Erzeugung eines Flüssigkeitsstrahles mit hoher Geschwindigkeit und in dem Strahl enthaltener Kavitationsblasen ein erster zylindrischer Innenraum vorgesehen, in den die Behandlungsflüssigkeit mittels der Pumpen gefördert wird, ferner ein zweiter zylindrischer Innenraum, der mit dem ersten Raum beispielsweise axial ausgefluchtet sein kann und mit dem ersten über mindestens eine in den zweiten Raum im wesentlichen tangential hineinführende Bohrung verbunden ist, so daß die Flüssigkeit aus dem ersten Raum in den zweiten gefördert und dabei in eine starke Wirbelströmungsbewegung versetzt werden kann. Der Querschnitt des zweiten Raumes verjüngt sich zur Düsenöffnung hin, aus der der Flüssigkeitsstrahl mit hoher Geschwindigkeit austritt.

Die Düsenöffnungen befinden sich in einem Abstand von 20 bis 300 mm zu den Oberflächen der Leiterplatten. Die hohe Geschwindigkeit der Behandlungsflüssigkeit wird mittels mindestens einer Hochdruckpumpe mit einem Druck von bis zu 30 bar erreicht. Der aus der Düse austretende Flüssigkeitsstrom wird gegen eine zu behandelnde Leiterplatte gerichtet. Der Flüssigkeitsstrom transportiert dabei zugleich Kavitationsblasen an die Leiterplattenoberfläche. Es wurde festgestellt, daß die Kavitationsblasen auch dann bestehen bleiben, wenn sie sich in einem Flüssigkeitstrom befinden, dessen Fließgeschwindigkeit um Größenordnungen über der bei schwingenden Ultraschallgeneratoren bestehenden Grenze von 0,06 Meter pro Sekunde liegt. Damit eignet sich die in Richtung der Leiterplattenoberfläche schnell strömende Behandlungsflüssigkeit zum Makrostoffaustausch und zugleich auch als Transportmittel für die Kavitationsblasen an die Diffusionsschicht zur Aktivierung des Mikrostoffaustausches. Weiterhin wurde bei den Versuchen eine überproportional schnelle chemische und elektrolytische Bearbeitung von Feinlöchern und Sacklöchem beobachtet, wenn sie dem Flüssigkeitsstrom, der Kavitationsblasen enthält, ausgesetzt werden.

Die Anforderungen für die chemische und elektrolytische Behandlung von horizontal transportierten und gefluteten Leiterplatten können damit erfüllt werden. Die Flüssigkeitsströmung sorgt für den nötigen Makrostoffaustausch an der Diffusionsschicht, und die mit dem Flüssigkeitsstrom mitgeführten Kavitationsblasen sorgen für den Mikrostoffaustausch an der viskosen Unterschicht.

Die Wirbelströmungsbewegung der aus den Düsen ausströmenden Behandlungsflüssigkeit wird durch im wesentlichen tangentiale Einspeisung der Behandlungsflüssigkeit in einen zu einer Düsenöffnung hinführenden zylindrischen Hohlraum in den Düsen gebildet. Ferner wird die Behandlungsflüssigkeit mit einem solchen Überdruck aus den Düsenöffnungen gefördert, daß sie mit einer linearen Geschwindigkeit von mindestens 2,5 Meter pro Sekunde ausströmt.

Um eine größere Flüssigkeitsmenge pro Zeiteinheit an die Leiterplattenoberfläche fördern zu können, besteht auch die Möglichkeit, mehrere Düsenöffnungen vorzusehen, deren jede mit jeweils einem zylindrischen Hohlraum, in den die Behandlungsflüssigkeit im wesentlichen tangential eingespeist wird, oder alle zusammen mit einem einzigen zylindrischen Hohlraum in Verbindung stehen.

Oberhalb der Leiterplatten wird mit bekannten Mitteln der horizontalen Leiterplattenanlagen ein Flüssigkeitsstauraum gebildet, zum Beispiel mit Quetschwalzen. Dieser Stauraum bildet das obere Behandlungsbad, das mit Behandlungsflüssigkeit geflutet wird. Zur elektrolytischen Behandlung befinden sich beidseitig, das heißt an der Ober- und Unterseite der Leiterplatte, die Anoden. Diese sind löslich und/oder unlöslich. Zwischen den Anoden oder dahinter mit entsprechenden Anodenöffnungen befinden sich die Düsen.

Durch das Fluten der zu behandelnden Leiterplatten mittels eines Flüssigkeitsstauraumes werden wesentliche Nachteile der bekannten Spritztechnik vermieden. Es sind keine Maßnahmen zur Steuerung des Spritzbildes auf der Leiterplatte erforderlich, weil die Grenzen der Flüssigkeitsströme unter dem Badspiegel fließend, also unscharf sind. Alle Oberflächen werden gleichmäßig mit Elektrolyt beaufschlagt. Der Elektrolyt läuft nicht von der oberen Seite der Leiterplatte ab. Die dadurch bedingten Probleme entfallen. Weil das Spritzen entfällt, besteht keine Schaumbildung der Behandlungsflüssigkeit. Deshalb können die Antifoam-Mittel entfallen. Dies wiederum erlaubt den Einsatz weiterer Chemikalien, die mit diesen Mitteln unverträglich sind. Zugleich wird das Abwasser entlastet, was die Kosten weiter reduziert. Der Eintrag von Sauerstoff in das Bad wird vermieden. Nachteilig bei der Behandlung gefluteter Leiterplatten nach den bekannten Verfahren ist jedoch die niedrige Prozeßgeschwindigkeit. Der Grund ist der unzureichende Stoffaustausch, insbesondere der Mikrostoffaustausch in die Diffusionsschicht hinein. Der Stoffaustausch erfolgt hier praktisch nur durch Diffusion. Entsprechend lang und unbefriedigend ist die Behandlungszeit. Diesen Nachteil löst die Erfindung durch Kombination der Leiterplattenflutung mit einer Makroanströmung von frischer Behandlungsflüssigkeit an die Diffusionsschicht der Leiterplattenoberfläche. Die anströmende Behandlungsflüssigkeit ist zugleich mit Kavitationsblasen angereichert. Die Blasen implodieren an der Diffusionsschicht. Dies bewirkt einen intensiven Mikrostoffaustausch in die Diffusionsschicht hinein und bis zur viskosen Unterschicht. Dadurch wird die Dicke der Diffusionsgrenzschicht, in der der Stofftransport nur noch durch Diffusion stattfindet, auf einen sehr kleinen Wert verringert. Durch den Makro- und Mikrostoffaustausch wird die Behandlungszeit drastisch reduziert. Sie liegt bei 50 Prozent der bekannten Spritztechnik. Durch den intensiven Mikrostoffaustausch werden auch die beschriebenen Probleme, die durch die Feinleitertechnik entstehen, gelöst. Das großflächige Anströmen der Leiterplattenoberflächen mit Behandlungsflüssigkeit führt dazu, daß größere Bereiche der Leiterplattenoberfläche gleichzeitig intensiv behandelt werden als bei Anwendung der bekannten Schwallwelle. Entsprechend kürzer kann die Anlage sein. Die Aktivzonen der einzelnen Prozesse verkürzen sich etwa auf die Hälfte im Vergleich zur Spritztechnik.

Der Düsenabstand zur Leiterplatte wird in Abhängigkeit vom Düsenöffnungswinkel so gewählt, daß die Leiterplattenoberflächen vollständig vom Elektrolytstrom getroffen werden. Der Abstand liegt zwischen 20 mm und 300 mm, vorzugsweise zwischen 50 mm und 150 mm. Durch dieses so ausgestattete Bad wird das Behandlungsgut horizontal transportiert. Zum Antrieb und zur Führung dienen Transportwalzen oder -scheiben.

Damit die Leiterplattenoberflächen beim Vorbeitransportieren an den Düsen beidseitig und auf der gesamten Breite möglichst gleichmäßig mit der Behandlungsflüssigkeit in Kontakt gebracht werden können, können vorzugsweise mehrere Düsen oberhalb und unterhalb der Transportebene, in der die Leiterplatten transportiert werden, vorgesehen werden. Auf beiden Seiten, das heißt oben und unten, ist quer zur Transportrichtung die Anzahl der Düsen so groß zu wählen, daß alle Oberflächen vom Behandlungsflüssigkeitsstrom mindestens einmal erreicht werden. Die Düsen werden in diesem Fall auf beiden Seiten der Leiterplatten gegenüberiiegend und derart angeordnet, daß quer zur Transportrichtung alle Oberflächenbereiche der Leiterplatten oder Leiterfolien von der ausströmenden Behandlungsflüssigkeit gleichmäßig erreicht werden. Der Versatz der Düsen zwischen Ober- und Unterseite wird so gewählt, daß einer oberen Düse keine untere gegenübersteht und umgekehrt. Vorzugsweise werden die Düsen auf den beiden Seiten der Leiterplatten gegenseitig versetzt angeordnet, damit sich die Flüssigkeitsstrahlen in den durch die Leiterplatten hindurchgehenden Bohrungen nicht gegenseitig behindern.

Die Düsen können auf jeder Seite der Leiterplatten in jeweils mindestens einer Reihe im wesentlichen quer zur Transportrichtung angeordnet sein. Der Abstand zwischen benachbarten Düsen auf jeder Seite der Leiterplatten sollte derart eingestellt werden, daß abhängig vom Öffnungswinkel der aus den Düsenöffnungen austretenden Behandlungsflüssigkeit quer zur Transportrichtung alle Oberflächenbereiche der Leiterplatten von der Behandlungsflüssigkeit erreicht werden können. Beispielsweise können die gegeneinander versetzten Düsen auf beiden Seiten der Leiterplatten abwechselnd gegeneinander versetzt angeordnet sein.

In einer anderen Ausführungsform können die Düsen jedoch auch direkt gegenüberliegend angeordnet sein. In diesem Fall müssen jedoch die auf beiden Seiten der Leiterplatten einander gegenüberliegend angeordneten Düsen wechselseitig zeitlich nacheinander ein- und ausgeschaltet werden. Damit behindern sich die Flüssigkeitsstrahlen der gegenüberliegenden Düsen bei der Lochwandbearbeitung der Leiterplatten nicht gegenseitig. Das abwechselnde Schalten erlaubt bei halber Transportgeschwindigkeit die Verkürzung der Aktivstrecke der Anlage auf die Hälfte, im Vergleich zur wechselseitigen Anordnung, wenn zugleich die Anzahl der Düsen verdoppelt wird.

Die Leiterplatten und Leiterfolien werden von Transportrollen oder Transportscheiben geführt. Die Rollen oder Scheiben sind zum Teil oder vollständig angetrieben. Insbesondere zwischen den Transportscheiben können die Leiterplatten nahezu unbehindert mit Behandlungsflüssigkeit angeströmt werden.

Zur weiteren Erläuterung der Erfindung und weiterer bevorzugter Ausführungsformen dienen die nachfolgenden schematischen Figuren.
- Fig. 1 -: Prinzip einer Vorrichtung zur chemischen Behandlung, Gesamtansicht,
- Fig. 2 -: Vorrichtung zur Erzeugung der Wirbelströmung,
- Fig. 3 -: Weitere Ausführungsform einer Vorrichtung zur Erzeugung der Wirbelströmung
- Fig. 4 -: Prinzip einer Vorrichtung mit Düsen.

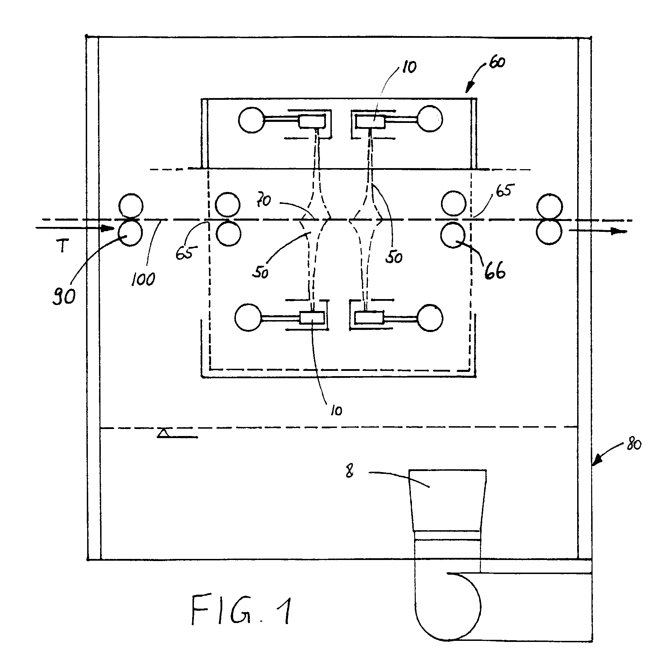

In Figur 1 ist das Prinzip einer horizontalen Durchlaufanlage zur Behandlung von Leiterplatten und Leiterfolien in Seitenansicht dargestellt. Die Leiterplatten durchlaufen die Anlage in der horizontalen Transportebene 100 von links nach rechts und werden hierbei durch angetriebene Transportrollen oder -scheiben 90 vorwärts bewegt. Nach Einlauf in den Flutbehälter 60 befindet sich die Leiterplatte vollständig innerhalb der Behandlungsflüssigkeit. Dort befinden sich auch Abquetschwalzen 66, die den Austritt der Behandlungsflüssigkeit aus dem Flutraum in dem Flutbehälter 60 behindern. Hierzu wird der untere Teil des Flutbehälters 60 unterhalb der Transportebene 100 mittels Pumpen (nicht dargestellt) mit der Behandlungsflüssigkeit befüllt. Der obere Teil des Flutbehälters 60 wird durch die aus den Düsen 10 ausströmende Behandlungsflüssigkeit befüllt, bis diese am oberen Rand des Flutbehälters 60 überläuft. An den schmalen seitlichen Schlitzen 65, durch die die Leiterplatten in den Flutbehälter 60 eingeführt werden, fließt ebenfalls kontinuierlich Behandlungsflüssigkeit in die umgebende Anlage, in der sicn ein Auffangbehälter 80 für die Behandlungsflüssigkeit befindet, ab. Die Behandlungsflüssigkeit im Auffangbehälter 80 wird über einen Ansaugstutzen 8 mittels Pumpen (nicht dargestellt) angesaugt und mit einem Druck von bis zu 30 bar in die Düsenrohre 30 gefördert.

Die Leiterplatten passieren beim Transport durch den Flutbehälter 60 die sich innerhalb der Behandlungsflüssigkeit befindenden Flüssigkeitsstrahlen 50, die aus den Düsen 10 austreten. Die Behandlungsflüssigkeit wird von den Düsenrohren 30 in die Düsen 10 gefördert. Mehrere Düsen 10 sind zum einen oberhalb und unterhalb der Transportebene 100, ferner in Transportrichtung T hintereinander und zum anderen in einer Reihe senkrecht zur Transportrichtung T und zur Zeichenebene angeordnet. Dadurch werden beim Durchlaufen der Behandlungszonen 70 alle Oberflächenbereiche der Leiterplatte mit dem Strahl der Behandlungsflüssigkeit in Kontakt gebracht.

In dem gezeigten Beispiel können die gegenüberliegenden Düsen 10 in den Reihen quer zur Transportrichtung T versetzt gegeneinander angeordnet sein. Falls sich die Düsen 10 jedoch direkt gegenüberstehen, müssen zur Vermeidung gegenseitiger Behinderung der einzelnen Flüssigkeitsstrahlen 50 die oberen und unteren Düsen 10 wechselseitig ein- bzw. ausgeschaltet werden.

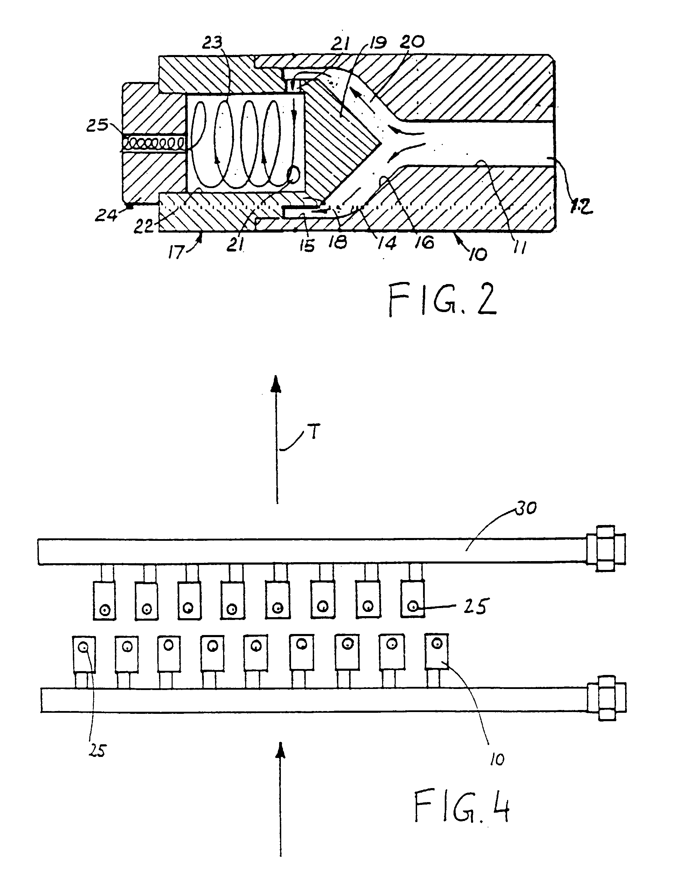

Ein Aufbau der Düse 10 ist in Figur 2 dargestellt. Die Düse 10 enthält einen axialen Flüssigkeitskanal 11 (zylindrischer Innenraum), der eine Einlauföffnung 12 aufweist. Die Einlauföffnung 12 kann jedoch auch, anders als in Figur 2 dargestellt, als seitliche Öffnung vorgesehen sein, so daß die Behandlungsflüssigkeit nicht axial sondern etwa radial in den Flüssigkeitskanal 11 eintritt. Die Einlauföffnung 12 ist mit einem Innengewinde zum Anschluß an das Düsenrohr 30 versehen. Der Flüssigkeitskanal 11 ist an einem Ende zur Bildung einer Mündung 14 erweitert, die einen zylindrischen Abschnitt 16 enthält. In die Mündung 14 ist ein hohler Einsatz 17 eingesetzt und verbunden. Der Einsatz 17 weist einen Abschnitt 18 auf, der einen geringeren Durchmesser hat als der Innendurchmesser der Mündung 14. Der Einsatz 17 ist an seinem zum Kanal 11 weisenden Ende konisch ausgebildet 19.

Durch den Einsatz 17 und die Mündung 14 wird ein ringförmiger Kanal gebildet, der mit dem inneren Hohlraum 22 des Einsatzes 17 über im wesentlichen tangential in den Hohlraum führende Bohrungen 21 im Einsatz 17 verbunden ist. Beispielsweise können drei derartige Bohrungen 21 in den Einsatz eingebracht werden, die um jeweils 120 ° zueinander versetzt sind. Alle tangentialen Bohrungen sind im gleichen Drehsinn zueinander ausgerichtet.

Das offene Ende des Einsatzes 17 ist durch eine Buchse 24 verschlossen. In dieser Buchse befindet sich eine weitere Bohrung 25 als Düsenöffnung, die einen wesentlich geringeren Durchmesser aufweist als der innere Hohlraum im Einsatz 17.

Unter Druck wird die Behandlungsflüssigkeit durch die Einlauföffnung 12 in den Flüssigkeitskanal 11 eingelassen und gelangt von dort über den ringförmigen Kanal zwischen dem Einsatz 17 und der Mündung 14 durch die tangential eingelassenen Bohrungen 21 in den inneren Hohlraum im Einsatz 17. Durch die im wesentlichen tangentiale Ausrichtung der Bohrungen erhält die Behandlungsflüssigkeit einen Drehimpuls und wird dadurch in dem Hohlraum in eine Drehbewegung 23 versetzt. Die Flüssigkeit wird beim weiteren Passieren der Bohrung 25 in der Buchse 24 wegen der Erhaltung des Drehimpulses in noch schnellere Drehbewegung versetzt. da die Flüssigkeit nunmehr wegen des geringeren Durchmessers der Bohrung 25 nur noch sehr kleine Drehungsamplituden durchführen kann. Gleichzeitig wird die Behandlungsflüssigkeit in der Bohrung 25 auch beschleunigt. Bei einer Düsenöffnung von etwa 4 mm passiert die Behandlungsflüssigkeit die Düsenöffnung mit einer linearen Geschwindigkeit von etwa 12 Meter pro Sekunde.

Da die Behandlungsflüssigkeit nach dem Austritt aus der Düsenöffnung als Wirbelströmung weiter rotiert und durch die Rotation der Strahl infolge der Zentrifugalkraft radial auseinanderstrebt, bilden sich innerhalb den entstehenden Strahlkegels Dampfblasen, die beim Auftreffen auf die Leiterplatten in der Behandlungszone 70 implodieren und dabei den Kavitationseffekt hervorbringen.

Um die Wirkung der Kavitation an der Leiterplattenoberfläche so wirkungsvoll wie möglich zu gestalten, muß der Abstand der Düsenaustrittsöffnung von der Leiterplattenoberfläche innerhalb eines Bereiches von 20 bis 300 mm, vorzugsweise zwischen 50 mm und 150 mm, betragen.

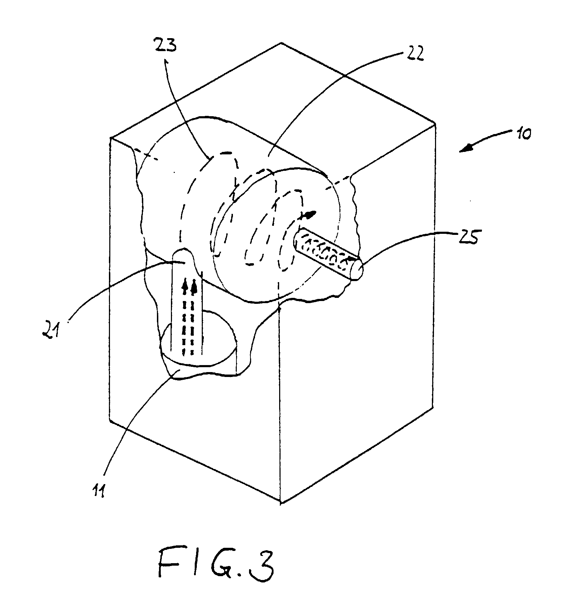

In Fig. 3 ist eine weitere Ausführungsform der Düse 10 dargestellt. In diesem Fall wird die Behandlungsflüssigkeit von unten kommend in den Hohlraum 11 in der Düse 10 eingespeist. Von dort gelangt sie unter Druck durch die Bohrung 21 tangential in den Hohlraum 22. Durch die tangentiale Einspeisung wird die Behandlungsflüssigkeit in dem Hohlraum 22 in eine schnelle Rotationsbewegung 23 versetzt. Der Hohlraum 22 verengt sich zur Düsenaustrittsöffnung 25 hin. Durch die schnelle Strömung der Behandlungsflüssigkeit wird diese in dem engen Kanal, der zur Düsenaustrittsöffnung 25 führt, in eine Rotationsbewegung versetzt, die eine höhere Frequenz aufweist als die im Hohlraum 22. Mit dieser Wirbelströmungsbewegung tritt die Behandlungsflüssigkeit aus der Düsenaustrittsöffnung 25 mit hoher Geschwindigkeit aus.

In Figur 4 ist die Anordnung von zwei Düsenstöcken für ein Ensemble oberhalb oder unterhalb der Transportebene dargestellt. Die zwei in Transportrichtung T hintereinander angeordneten Düsenstöcke bestehen aus je einem Düsenrohr 30 und an diesem befestigten Düsen 10 mit Düsenöffnungen 25. Durch die versetzte Anordnung der Düsen in den beiden Reihen kann eine weitere Vergleichmäßigung der Behandlung der Leiterplattenoberflächen erreicht werden.

Die Anwendung des Verfahrens ist besonders wirksam bei der Bearbeitung von Feinleiterplatten mit Feinbohrungen und Sacklöchern. Innerhalb einer Kette von Bädern einer Transferanlage für Leiterplatten werden unterschiedliche Behandlungsflüssigkeiten bei unterschiedlichen Temperaturen verwendet. Zur Serienfertigung und aus Gründen der Kalibrierung der Düsen und der Steuerung des Behandlungsergebnisses mit dem Verfahren sollen möglichst gleiche Düsensysteme verwendet werden. Aus diesem Grunde kann die zur Erzeugung der Wirbelströmung verwendete Pumpe auch in Abhängigkeit von der verwendeten Flüssigkeit und deren Temperatur mit variierendem Druck und variierendem Volumenstrom betrieben oder geregelt werden. Dies geschieht in gewissen Grenzen bevor eine andere Düsengröße/Durchmesser der Öffnung eingesetzt wird, damit das Behandlungsergebnis bzw. die Kavitationsblasenbildung möglichst gleich bleibt.

## Patentansprüche

1. Verfahren zum chemischen und elektrolytischen Behandeln sowie Spülen von Leiterplatten und Leiterfolien mit hoher Präzision und Geschwindigkeit mit einer Behandlungsflüssigkeit, durch die die Leiterplatten und Leiterfolien in horizontaler Lage und honzontaler Transportrichtung in einer Transportebene transportiert werden, wobei
- die Leiterplatten oder Leiterfolien durch ein Bad der Behandlungsflüssigkeit hindurchgeführt werden, indem die Leiterplatten oder Leiterfolien mit ihrer Unterseite mit der Behandlungsflüssigkeit in einem Behandlungsbad und/oder mit ihrer Oberseite mit der Behandlungsflüssigkeit in einem durch geeignete Mittel gebildeten Flüssigkeitsstauraum in Kontakt gebracht werden,
- mittels innerhalb der Behandlungsflüssigkeit und im Abstand von 20 bis 300 mm zur Transportebene (100) angeordneter Düsen (10) Behandlungsflüssigkeit an die Oberflächen der Leiterplatten oder Leiterfolien als Flüssigkeitsstrahl (50) so gefördert wird, daß
- innerhalb des Flüssigkeitsstrahles (50) hydrodynamisch gebildete Kavitationsblasen, welche durch Ausströmen einer unter so hohem Druck stehenden, daß Kavitationsblasen im Flüssigkeitsstrahl gebildet werden, und in Wirbelströmungsbewegung versetzten Behandlungsflüssigkeit aus den Düsen (10) erzeugt werden, an die Oberflächen der Leiterplatten und Leiterfolien transportiert werden.

2. Verfahren nach Anspruch 1, dadurch gekennzeichnet, daß die Wirbelströmungsbewegung (23) der aus den Düsen (10) ausströmenden Behandlungsflüssigkeit durch im wesentlichen tangentiale Einspeisung der Behandlungsflüssigkeit in einen zu einer Düsenöffnung (25) hinführenden zylindrischen Hohlraum (22) in den Düsen (10) gebildet wird.

3. Verfahren nach einem der vorstehenden Ansprüche, dadurch gekennzeichnet, daß die Rotationsgeschwindigkeit der Wirbelströmungsbewegung (23) durch Verengung des zylindrischen Hohlraums (22) in Ricntung aer Düsenöffnung (25) erhöht wird.

4. Verfahren nach einem der vorstehenden Ansprüche, dadurch gekennzeichnet, daß der Druck, mit dem die Behandlungsflüssigkeit aus den Düsenöffnungen (25) gefördert wird, so gewählt wird, daß sie mit einer linearen Geschwindigkeit von mindestens 2,5 Meter pro Sekunde ausströmt.

5. Verfahren nach einem der vorstehenden Ansprüche, dadurch gekennzeichnet, daß die Behandlungsflüssigkeit aus mehreren in einer Düse (10) vorgesehenen Düsenöffnungen (25) gefördert wird, deren jede mit jeweils einem zylindrischen Hohlraum (22), in den die Behandlungsflüssigkeit im wesentlichen tangential eingespeist wird, oder alle zusammen mit einem einzigen zylindrischen Hohlraum (22) in Verbindung stehen.

6. Verfahren nach einem der vorstehenden Ansprüche, dadurch gekennzeichnet, daß die Düsen (10) oberhalb und unterhalb der Transportebene (100) gegenüberliegend und derart angeordnet werden, daß quer zur Transportrichtung (T) alle Oberflächenbereiche der Leiterplatten oder Leiterfolien von der ausströmenden Behandlungsflüssigkeit gleichmäßig erreicht werden.

7. Verfahren nach einem der vorstehenden Ansprüche, dadurch gekennzeichnet, daß die in dem Bad enthaltene Behandlungsflüssigkeit mittels mindestens einer Pumpe unter einem Druck von mindestens 10 bar in die Düsen (10) gefördert wird.

8. Verfahren nach einem der vorstehenden Ansprüche, dadurch gekennzeichnet, daß die Düsen (10) oberhalb und unterhalb der Transportebene (100) gegenseitig versetzt angeordnet sind.

9. Verfahren nach einem der Ansprüche 1 bis 7, dadurch gekennzeichnet, daß oberhalb und unterhalb der Transportebene (100) einander gegenüberliegend angeordnete Düsen (10) wechselseitig zeitlich nacheinander ein- und ausgeschaltet werden.

10. Verfahren nach einem der vorstehenden Ansprüche, dadurch gekennzeichnet, daß die Leiterplatten und Leiterfolien von mindestens einem Element (90), ausgewählt aus der Gruppe von angetriebenen und nicht angetriebenen Transportscheiben, geführt werden.

11. Vorrichtung zur Durchführung des Verfahren nach einem der vorstehenden Ansprüche, bei der
- ein Behälter (80) zur Aufnahme von Behandlungsflüssigkeit,
- Mittel zum Transport der oberhalb des Behälters geführten und in honzontaler Lage angeordneten Leiterplatten und Leiterfolien in horizontaler Richtung in einer Transportebene (100),
- Mittel zum Bilden eines Flüssigkeitsstauraumes oberhalb der Transportebene (100) und/oder einen so unterhalb der Transportebene (100) angeordneten Tentbehälter (60) zur Aufnahme der Behandlungsflüssigkeit daß die Unterseiten der Leiterplatten mit der Behandlungsflüssigkeit im Tentbehälter (60) in Kontakt gebracht werden können,
- in einem Abstand von 20 bis 300 mm zu mindestens einer Seite der Transportebene (100) angeordnete Düsen (10) zum Fördem der Behandlungsflüssigkeit an die Oberflächen der Leiterplatten und Leiterfolien und
- mindestens eine Pumpe zum Fördern der Behandlungsflüssigkeit in die Düsen (10) mit einem Druck von mindestens 10 bar
vorgesehen sind, wobei in den Düsen (10) zur Erzeugung eines Flüssigkeitsstrahles (50) mit hoher Geschwindigkeit und in dem Strahl (50) enthaltener Kavitationsblasen
- ein erster zylindrischer Innenraum (11) vorgesehen ist, in den die Behandlungsflüssigkeit mittels der Pumpen gefördert wird,
- ferner ein zweiter zylindrischer Innenraum (22), der mit dem ersten Raum (11) über mindestens eine in den zweiten Raum (22) im wesentlichen tangential hineinführende Bohrung (21) verbunden ist, so daß die Flüssigkeit aus dem ersten Raum (11) in den zweiten (22) gefördert und dabei in eine Wirbelströmungsbewegung (23) versetzt werden kann und
- sich der Querschnitt des zweiten Raumes (22) zu einer Düsenöffnung (25) hin verjüngt, aus der der Flüssigkeitsstrahl (50) mit so hoher Geschwindigkeit austritt, daß Kavitationsblasen im Flüssigkeitsstrahl (50) gebildet werden.

12. Vorrichtung nach Anspruch 11, gekennzeichnet durch mehrere oberhalb und unterhalb der Transportebene (100) angeordnete Düsen (10).

13. Vorrichtung nach Anspruch 12, dadurch gekennzeichnet, daß die Düsen (10) oberhalb und unterhalb der Transportebene (100) in jeweils mindestens einer Reihe im wesentlichen quer zur Transportrichtung (T) angeordnet sind.

14. Vorrichtung nach Anspruch 13, dadurch gekennzeichnet, daß der Abstand zwischen benachbarten Düsen (10) oberhalb und unterhalb der Transportebene (100) derart gewählt wird, daß abhängig vom Öffnungswinkel der aus den Düsenöffnungen (25) austretenden Behandlungsflüssigkeit quer zur Transportrichtung (T) alle Oberflächenbereiche der Leiterplatten und Leiterfolien von der Behandlungsflüssigkeit erreicht werden können.

15. Vorrichtung nach einem der Ansprüche 11 bis 14, dadurch gekennzeichnet, daß die Düsen (10) beidseitig zur Transportebene (100) abwechselnd und gegenseitig versetzt angeordnet sind.

16. Vorrichtung nach einem der Ansprüche 11 bis 15, gekennzeichnet durch sich quer zur Transportrichtung (T) erstreckende Walzen (66) oberhalb der Transportebene (100) als Mittel zum Bilden eines Flüssigkeitsstauraumes.

17. Verwendung der Vorrichtung nach einem der Ansprüche 11 bis 16 zum chemischen und elektrolytischen Behandeln sowie Spülen von Leiterplatten oder Leiterfolien mit hoher Präzision und Geschwindigkeit mit einer Behandlungsflüssigkeit, durch die die Leiterplatten und Leiterfolien in horizontaler Lage und horizontaler Transportrichtung transportiert werden.

18. Verwendung nach Anspruch 17, dadurch gekennzeichnet, daß die Geschwindigkeit und der Druck und/oder der Durchmesser der Düsenöffnung zur Erzielung einer etwa gleichbleibenden Kavitationsbildung in Abhängigkeit von der Art und/oder der Temperatur der Behandlungsflüssigkeit eingestellt wird.

## Claims

1. Method of chemically and electrolytically treating and rinsing printed circuit boards and conductor films with great accuracy and at high speed using a treatment fluid, through which the printed circuit boards and conductor films are conveyed in a plane of conveyance in a horizontal position and horizontal direction of conveyance, wherein
- the printed circuit boards or conductor films are guided through a bath of the treatment fluid so that the printed circuit boards or conductor films are brought into contact, with their underside, with the treatment fluid in a treatment bath and/or, with their upper side, with the treatment fluid in a fluid storage chamber formed by suitable means,
- treatment fluid is conveyed to the surfaces of the printed circuit boards or conductor films as fluid jet (50) by means of nozzles (10), which are disposed internally of the treatment fluid and at a spacing of between 20 and 300 mm from the plane of conveyance (100), so that
- cavitation bubbles, which are formed hydrodynamically internally of the fluid jet (50) and are produced as a result of a treatment fluid emerging from the nozzles (10), are conveyed to the surfaces of the printed circuit boards and conductor films, said fluid being under such a high pressure that cavitation bubbles are formed in the fluid jet, and said fluid being set in vortical motion.

2. Method according to claim 1, characterised in that the vortical motion (23) of the treatment fluid emerging from the nozzles (10) is formed by substantially tangentially feeding the treatment fluid into a cylindrical cavity (22) in the nozzles (10), said cavity extending towards a nozzle opening (25).

3. Method according to one of the preceding claims, characterised in that the rotational speed of the vortical motion (23) is increased by narrowing the cylindrical cavity (22) in the direction towards the nozzle opening (25).

4. Method according to one of the preceding claims, characterised in that the pressure, at which the treatment fluid is conveyed from the nozzle openings (25), is so selected that it emerges at a linear speed of at least 2.5 metres per second.

5. Method according to one of the preceding claims, characterised in that the treatment fluid is conveyed from a plurality of nozzle openings (25) provided in a nozzle (10), each of said openings communicating with a respective cylindrical cavity (22), into which the treatment fluid is fed substantially tangentially, or all of said openings together communicate with a single cylindrical cavity (22).

6. Method according to one of the preceding claims, characterised in that the nozzles (10) are disposed above and below the plane of conveyance (100) opposite one another and in such a manner that all of the surface regions of the printed circuit boards or conductor films are uniformly reached by the emerging treatment fluid transversely relative to the direction of conveyance (T).

7. Method according to one of the preceding claims, characterised in that the treatment fluid contained in the bath is conveyed into the nozzles (10) by means of at least one pump under a pressure of at least 10 bar.

8. Method according to one of the preceding claims, characterised in that the nozzles (10) are disposed above and below the plane of conveyance (100) in a mutually offset manner.

9. Method according to one of claims 1 to 7, characterised in that nozzles (10), which are disposed above and below the plane of conveyance (100) so as to lie opposite one another, are connected and disconnected alternately in chronological succession.

10. Method according to one of the preceding claims, characterised in that the printed circuit boards and conductor films are guided by at least one element (90) selected from the group of driven and non-driven conveyor discs.

11. Apparatus for accomplishing the method according to one of the preceding claims, wherein are provided
- a container (80) for accommodating treatment fluid,
- means for conveying the printed circuit boards and conductor films, which are guided above the container and are disposed in the horizontal position, in a horizontal direction in a plane of conveyance (100),
- means for forming a fluid storage chamber above the plane of conveyance (100) and/or a flood container (60) for accommodating the treatment fluid, which container (60), is so disposed beneath the plane of conveyance (100) that the undersides of the printed circuit boards can be brought into contact with the treatment fluid in the flood container (60),
- nozzles (10), disposed at a spacing of between 20 and 300 mm from at least one side of the plane of conveyance (100), for conveying the treatment fluid to the surfaces of the printed circuit boards and conductor films, and
- at least one pump for conveying the treatment fluid into the nozzles (10) at a pressure of at least 10 bar, in order to produce a high-speed fluid jet (50) and cavitation bubbles, which are contained in the jet (50), there are provided in the nozzles (10)
- a first cylindrical internal chamber (11) , into which the treatment fluid is conveyed by means of the pumps,
- a second cylindrical internal chamber (22) , which is connected to the first chamber (11) via at least one bore (21), which extends substantially tangentially into the second chamber (22), so that the fluid can be conveyed from the first chamber (11) into the second chamber (22) and can thereby be set into vortical motion (23), and
- the cross-section of the second chamber (22) tapering towards a nozzle opening (25), from which the fluid jet (50) emerges at such a high speed that cavitation bubbles are formed in the fluid jet (50).

12. Apparatus according to claim 11, characterised by a plurality of nozzles (10) disposed above and below the plane of conveyance (100).

13. Apparatus according to claim 12, characterised in that the nozzles (10) are disposed above and below the plane of conveyance (100) in at least one respective row substantially transversely relative to the direction of conveyance (T).

14. Apparatus according to claim 13, characterised in that the spacing between adjacent nozzles (10) above and below the plane of conveyance (100) is selected in such a manner that all of the surface regions of the printed circuit boards and conductor films can be reached by the treatment fluid in dependence on the angle of opening of the treatment fluid, which emerges from the nozzle openings (25), transversely relative to the direction of conveyance (T).

15. Apparatus according to one of claims 11 to 14, characterised in that the nozzles (10) are disposed on each side so as to alternately and mutually offset from the plane of conveyance (100).

16. Apparatus according to one of claims 11 to 15, characterised by rollers (66) above the plane of conveyance (100), which rollers extend transversly relative to the direction of conveyance (T) and serve as the means for forming a fluid storage chamber.

17. Use of the apparatus according to one of claims 11 to 16 for chemically and electrolytically treating and rinsing printed circuit boards or conductor films with great accuracy and at high speed using a treatment fluid, through which the printed circuit boards and conductor films are conveyed in a horizontal position and in a horizontal direction of conveyance.

18. Use according to claim 17, characterised in that the speed and the pressure and/or the diameter of the nozzle opening for achieving a substantially constant cavitation formation are set in dependence on the type and/or the temperature of the treatment fluid.

## Revendications

1. Procédé de traitement chimique et électrolytique, ainsi que de rinçage des plaquettes et des feuilles de circuits imprimés, effectué avec une grande précision et à vitesse élevée avec un liquide de traitement, à travers lequel les plaquettes et les feuilles de circuits imprimés sont transportées en position horizontale et dans le sens horizontal par rapport à un plan de transport, dans lequel procédé
- les plaquettes ou les feuilles de circuits imprimés sont acheminées à travers un bain constitué par le liquide de traitement, les plaquettes et les feuilles de circuits imprimés étant mises en contact par leur face inférieure avec le liquide de traitement dans un bain de traitement et/ou par leur face supérieure avec le liquide de traitement dans un espace de retenue du liquide formé par des moyens appropriés,
- le liquide de traitement est projeté sur les surfaces des plaquettes et des feuilles de circuits imprimés sous forme de jet de liquide (50) à l'aide de buses (10) montées dans le liquide de traitement et à une distance de 20 à 300 mm du plan de transport (100),
- des bulles de cavitation dues à un effet hydrodynamique dans le jet de liquide (50), qui sont produites par la projection du liquide de traitement hors des buses (10) à une pression si élevée que des bulles de cavitation se forment dans le jet de liquide (50) et par la transformation du liquide traitement en un mouvement tourbillonnaire, et sont transportées sur les surfaces des plaquettes et des feuilles de circuits imprimés.

2. Procédé selon la revendication 1, caractérisé en ce que le mouvement tourbillonnaire (23) du liquide de traitement giclant hors des buses (10) est formé dans les buses (10) par une injection du liquide de traitement sensiblement selon une tangente vers l'intérieur d'une cavité cylindrique (22) communiquant avec un orifice de buse (25).

3. Procédé selon l'une quelconque des revendications précédentes, caractérisé en ce que la vitesse de rotation du mouvement tourbillonnaire (23) est augmentée par un rétrécissement de la cavité cylindrique (22) en direction de l'orifice de buse (25).

4. Procédé selon l'une quelconque des revendications précédentes, caractérisé en ce que la pression, avec laquelle le liquide de traitement gicle hors des orifices des buses (25), est choisie de telle sorte que le liquide de traitement se répand avec une vitesse linéaire d'au moins 2,5 mètres par seconde.

5. Procédé selon l'une quelconque des revendications précédentes, caractérisé en ce que le liquide de traitement gicle hors de plusieurs orifices (25) réalisés dans une buse (10), dont chacun communique respectivement avec une cavité cylindrique (22), dans laquelle le liquide de traitement est injecté sensiblement selon une tangente, ou tous lesdits orifices communiquent avec une seule cavité cylindrique (22).

6. Procédé selon l'une quelconque des revendications précédentes, caractérisé en ce que les buses (10) sont disposées face à face au-dessus et au-dessous du plan de transport (100) et de telle sorte que le liquide de traitement giclant hors desdites buses parvienne de manière régulière, transversalement par rapport au sens de transport (T), sur toutes les zones de surface des plaquettes et des feuilles de circuits imprimés.

7. Procédé selon l'une quelconque des revendications précédentes, caractérisé en ce que le liquide de traitement contenu dans le bain est acheminé vers les buses (10) par au moins une pompe sous une pression de 10 bar au moins.

8. Procédé selon l'une quelconque des revendications précédentes, caractérisé en ce que les buses (10) sont disposées de manière décalée les unes par rapport aux autres au-dessus et au-dessous du plan de transport (100).

9. Procédé selon l'une quelconque des revendications 1 à 7, caractérisé en ce que les buses (10) disposées face à face au-dessus et au-dessous du plan de transport (100) sont connectées et déconnectées alternativement dans le temps les unes après les autres.

10. Procédé selon l'une quelconque des revendications précédentes, caractérisé en ce que les plaquettes et les feuilles de circuits imprimés sont guidées par au moins un élément (90), sélectionné dans un groupe de plaques de transport actionnées ou non actionnées.

11. Dispositif destiné à la mise en oeuvre du procédé selon l'une quelconque des revendications précédentes, dans lequel dispositif il est prévu
- une cuve (80) destinée à recevoir le liquide de traitement,
- des moyens destinés à transporter dans un plan de transport (100) dans le sens horizontal les plaquettes et les feuilles de circuits imprimés guidées au-dessus de la cuve et disposées en position horizontale,
- des moyens destinés à former un espace de retenue au-dessus du plan de transport (100) et/ou un récipient d'injection (60), destiné à recevoir le liquide de traitement et disposé en dessous du plan de transport (100) de telle sorte que les faces inférieures des plaquettes de circuits imprimés soient mises en contact avec le liquide de traitement dans le récipient d'injection (60),
- des buses (10), disposées à une distance de 20 à 300 mm du plan de transport (100) sur au moins un côté et destinées à acheminer le liquide de traitement sur les surfaces des plaquettes et les feuilles de circuits imprimés, et
- au moins une pompe destinée à refouler le liquide de traitement dans les buses (10) avec une pression de 10 bar au moins,
dans lequel dispositif il est prévu de réaliser dans les buses (10), pour produire un jet de liquide (50) à vitesse élevée et des bulles de cavitation contenues dans le jet (50),
- une première cavité intérieure cylindrique (11), dans laquelle est acheminé le liquide de traitement à l'aide des pompes,
- en outre, une deuxième cavité intérieure cylindrique (22), qui est reliée avec la première cavité (11) par au moins un orifice (21) pénétrant sensiblement selon une tangente dans la deuxième cavité (22), de telle sorte que le liquide puisse être acheminé de la première cavité (11) vers la deuxième cavité (22) et puisse être transformé à cet effet en un mouvement tourbillonnaire (23), et
- la section de la deuxième cavité (22) se rétrécit en direction d'un orifice de buse (25), hors duquel gicle le jet de liquide (50) avec une vitesse si élevée qu'il se forme des bulles de cavitation dans le jet de liquide (50).

12. Dispositif selon la revendication 11, caractérisé en ce que plusieurs buses (10) sont disposées au-dessus et au-dessous du plan de transport (100).

13. Dispositif selon la revendication 12, caractérisé en ce que les buses (10) sont disposées au-dessus et au-dessous du plan de transport (100) en formant respectivement au moins une rangée sensiblement transversale au sens de transport (T).

14. Dispositif selon la revendication 13, caractérisé en ce que la distance entre deux buses (10) voisines disposées au-dessus et au-dessous du plan de transport (100) est choisie de telle sorte que, en fonction de l'angle d'ouverture du liquide de traitement giclant hors des orifices de buse (25) transversalement par rapport au sens de transport (T), le liquide de traitement puisse atteindre toutes les zones de surface des plaquettes et des feuilles de circuits imprimés.

15. Dispositif selon l'une quelconque des revendications 11 à 14, caractérisé en ce que les buses (10) sont disposées de part et d'autre du plan de transport (100) altemativement et de manière décalée les unes par rapport aux autres.

16. Dispositif selon l'une quelconque des revendications 11 à 15, caractérisé par des cylindres (66) disposés transversalement par rapport au sens de transport (T) au-dessus du plan de transport (100) pour constituer des moyens destinés à former un espace de retenue du liquide.

17. Utilisation du dispositif selon l'une quelconque des revendications 11 à 16, pour le traitement chimique et électrolytique, ainsi que le rinçage des plaquettes et des feuilles de circuits imprimés, effectué avec une grande précision et à vitesse élevée avec un liquide de traitement, à travers lequel sont acheminées dans le sens de transport horizontal les plaquettes et les feuilles de circuits imprimés en position horizontale.

18. Utilisation selon la revendication 17, caractérisée en ce que la vitesse et la pression et/ou le diamètre de l'orifice de buse sont choisis en fonction de la nature et/ou de la température du liquide de traitement pour faire apparaître une cavitation homogène.
